# EUROPEAN PATENT SPECIFICATION

(11) **EP 2 825 011 B1**
(45) Date of publication and mention of the grant of the patent: **24.08.2016**
(21) Application number: 14173910.2
(22) Date of filing: 25.06.2014
(51) Int. Cl.: H05K 7/20

(54) **Traction converter and railway vehicle**
Traktionsumrichter und Schienenfahrzeug
Convertisseur de traction et véhicule ferroviaire

(30) Priority: 10.07.2013 JP 2013144102
(43) Date of publication of application: 14.01.2015
(73) Proprietor: Hitachi, Ltd., Tokyo 100-8280 (JP)
(72) Inventor: Yasuda, Yosuke, Chiyoda-ku, Tokyo 100-8280 (JP); Funakoshi, Sunao, Chiyoda-ku, Tokyo 100-8280 (JP); Tanaka, Takeshi, Chiyoda-ku, Tokyo 100-8280 (JP); Terakado, Shuichi, Chiyoda-ku, Tokyo 100-8280 (JP)
(74) Representative: Gill, Stephen Charles

(56) References cited:
- EP-A1- 2 574 159
- EP-A2- 2 469 996
- JP-A- 2000 161 880

## Description

### BACKGROUND OF THE INVENTION

### Field of the Invention

The present invention relates to a traction converter, and particularly to a traction converter for an electric railway vehicle.

### Description of the Related Art

In an electric railway vehicle, traction converters such as converters and inverters are mounted for controlling an electric motor to drive the vehicle. These traction converters perform traction conversion by performing a switching at a radio frequency with semiconductor elements such as an IGBT (Insulated Gate Bipolar Transistor) and a GTO (Gate Turn Off Thyristor).

In the semiconductor elements, heat is generated at the times of current-carrying and switching. When the semiconductor elements become at a high temperature by this heat, there are fears of a decrease in conversion efficiency and an element breakdown, and therefore, the semiconductor elements need to be cooled so as to be in a predetermined temperature range. The traction converter is mounted mainly under the floor of the vehicle or the like, in which a mounting space is limited, and therefore, a cooler is provided for efficiently cooling the plural semiconductor elements in a small and lightweight device configuration.

When cooling wind is supplied to the cooler, the cooling wind receives the heat from semiconductor elements provided at the up-wind side, and thereby becomes at a higher temperature as going to the down-wind side. In connection with this, semiconductor elements at the down-wind side tend to be at a high temperature. Therefore, for efficiently cooling the semiconductor elements, it is necessary to configure the cooler such that the temperatures of the semiconductor elements are equalized.

As a component of the cooler, a heat pipe is often used. The heat pipe, in which coolant such as pure water is encapsulated in the interior, is a device to efficiently transport heat in a cycle in which the coolant is evaporated at a heat receiving part and the heat is transported to a heat radiation part, then the coolant is condensed at the heat radiation part and is returned to the heat receiving part. As a cooler intended for a temperature equalization by a combination of the heat pipe and heat radiation fins, there is known a cooler shown in Japanese Patent Laid-Open No. 2000-161880 (Patent Document 1). The cooler is constituted by plural heat radiation fins that are provided roughly vertically and that radiate the heat by the natural convection cooling to the air, a single heat receiving block to which plural semiconductor elements are attached, and plural heat pipes that connect the heat radiation fins and the heat receiving block. The plural heat pipes are provided so as to be inclined relative to the horizontal, for placing the evaporation part side below the condensation part. Further, the plural heat radiation fins are provided such that the interval of heat radiation fins at the upper side is smaller than that of heat radiation fins at the lower side, and the number of the heat radiation fins at the upper side is greater than that of the heat radiation fins at the lower side.

Meanwhile, a cooler shown in Japanese Patent No. 4948625 (Patent Document 2) is also known. The cooler is constituted by a heat receiving block that is thermally connected with heat generation elements, plural heat pipes that are erectly provided on a surface of the heat receiving block, and heat radiation fin groups each of which has plural fins attached to the heat pipe, and cooling wind flows in the direction parallel to the heat receiving block. The heat radiation fin groups are arranged plurally and tandemly along the flow direction of the cooling wind. Of the plural heat radiation fin groups, a heat radiation fin group arranged at the up-wind side of the cooling wind has a larger fin pitch than the fin pitch of a heat radiation fin group arranged at the down-wind side of the cooling wind. Further, assuming that the heat radiation fin groups constitute a single heat radiation fin group that is formed by a plurality of single-fins extending from the up-wind to the down-wind, the positions of group gaps between the plural heat radiation fin groups are positions of the surface temperature of the heat radiation fin of the single heat radiation fin group at which the temperature difference between the up-wind and down-wind of the fin surface of the single heat radiation fin group is evenly divided by the number of the plural heat radiation fin groups.

### SUMMARY OF THE INVENTION

In the cooler described in Japanese Patent Laid-Open No. 2000-161880 (Patent Document 1), at the upper side, that is, the down-wind side, the fin pitch is smaller and the number is greater. However, in this configuration, the respective heat radiation fin areas at the up-wind side and down-wind side are not optimal, and therefore, there is a problem in that the temperatures of the respective semiconductor elements are not equalized, resulting in an inefficient cooling.

Further, in the cooler described in Japanese Patent No. 4948625 (Patent Document 2), for example, when the heat radiation fin groups are divided into three, a division point between the up-wind side fins and the mid-wind side fins, and a division point between the mid-wind side fins and the down-wind side fins are placed at a more up-wind side than positions at which the fins are evenly divided into three in the cooling wind flow direction, that is, a region occupied by the down-wind side fins, at which the pitch of the heat radiation fins is small and the number is great, is widened. Therefore, there is a problem in that the cooler is heavy. Moreover, in the configuration described in Japanese Patent No. 4948625 (Patent Document 2), the effect is obtained for specific fin pitches, and there is also a problem in that the temperatures cannot be equalized when the fin pitches are changed. In addition, the up-wind, mid-wind and down-wind fins do not have the same shape, and therefore, there is also a problem in that the production cost is high.

The present invention has an object to provide a traction converter that makes it possible to equalize the temperatures of the semiconductor elements by combining the configurations of the heat radiation fins appropriate for the configuration of the semiconductor elements, and to efficiently cool the semiconductor elements in a lightweight device configuration.

A traction converter according to a first aspect of the present invention that solves the above problems is a traction converter including: plural semiconductor elements included in a traction converting circuit; and a cooler to radiate heat from the plural semiconductor elements to outside air, the cooler including a heat receiving block, plural heat pipes and plural heat radiation fins, the plural semiconductor elements being arrayed on one surface of the heat receiving block, heat receiving parts of the plural heat pipes being buried in the other surface of the heat receiving block, heat radiation parts of the plural heat pipes being erectly provided so as to protrude from the heat receiving block, the plural heat radiation fins being joined to the heat radiation parts, the semiconductor elements being provided at three places in a cooling wind flow direction, in which, when regions at which the plural heat radiation fins are provided are defined at even intervals in the cooling wind flow direction as an up-wind region, a mid-wind region and a down-wind region, a heat radiation fin surface area at the up-wind region is in a range of 0.33 to 0.42 times of a heat radiation fin surface area at the down-wind region, and a heat radiation fin surface area at the mid-wind region is in a range of 0.42 to 0.63 times of the heat radiation fin surface area at the down-wind region.

A traction converter according to a second aspect of the present invention is a traction converter including: plural semiconductor elements included in a traction converting circuit; and a cooler to radiate heat from the plural semiconductor elements to outside air, the cooler including a heat receiving block, plural heat pipes and plural heat radiation fins, the plural semiconductor elements being arrayed on one surface of the heat receiving block, heat receiving parts of the plural heat pipes being buried in the other surface of the heat receiving block, heat radiation parts of the plural heat pipes being erectly provided so as to protrude from the heat receiving block, the plural heat radiation fins being joined to the heat radiation parts, the semiconductor elements being provided at two places in a cooling wind flow direction, in which, when regions at which the plural heat radiation fins are provided are defined at even intervals in the cooling wind flow direction as an up-wind region and a down-wind region, a heat radiation fin surface area at the up-wind region is in a range of 0.54 to 0.73 times of a heat radiation fin surface area at the down-wind region.

A traction converter according to a third aspect of the present invention is a traction converter comprising: plural semiconductor elements included in a traction converting circuit; and a cooler to radiate heat from the plural semiconductor elements to outside air, the cooler including a heat receiving block, plural heat pipes and plural heat radiation fins, the plural semiconductor elements being arrayed on one surface of the heat receiving block, heat receiving parts of the plural heat pipes being buried in the other surface of the heat receiving block, heat radiation parts of the plural heat pipes being erectly provided so as to protrude from the heat receiving block, the plural heat radiation fins being joined to the heat radiation parts, the semiconductor elements being provided at four places in a cooling wind flow direction, in which, when regions at which the plural heat radiation fins are provided are defined at even intervals in the cooling wind flow direction as a most up-wind region, an up-wind region, a down-wind region and a most down-wind region, a heat radiation fin surface area at the most up-wind region is in a range of 0.21 to 0.42 times of a heat radiation fin surface area at the most down-wind region, a heat radiation fin surface area at the up-wind region is in a range of 0.25 to 0.63 times of the heat radiation fin surface area at the most down-wind region, and a heat radiation fin surface area at the down-wind region is in a range of 0.42 to 0.73 times of the heat radiation fin surface area at the most down-wind region.

According to the first aspect of the present invention, the heat radiation fin areas at the up-wind region and the mid-wind region, at which the temperature of the cooling wind is low, is smaller than that at the down-wind region, at which the temperature of the cooling wind rises, that is, the numbers of the heat radiation fins are less than that at the down-wind region, and the heat radiation fin areas at the respective regions are set such that the temperatures of the respective semiconductor elements are equalized. Thereby, it is possible to efficiently cool the semiconductor elements in a lightweight device configuration. Also, in the second and third aspects of the present invention, it is possible to obtain the same effect by the same principle as the first aspect of the present invention. Thus, by optimally combining the configurations of the heat radiation fins in accordance with the configuration of the semiconductor elements, it is possible to equalize the temperatures of the semiconductor elements and to efficiently cool the semiconductor elements in a lightweight device configuration.

### BRIEF DESCRIPTION OF THE DRAWINGS

FIG. 1 is a perspective view showing the overall configuration of a traction converter according to a first embodiment of the present invention;
FIG. 2 is a top view of FIG. 1;
FIG. 3 is a cross-sectional view taken along A-A of FIG. 2;
FIG. 4 is a bottom view of a cooler to be mounted in the traction converter according to the first embodiment of the present invention;
FIG. 5 is a top view of the cooler to be mounted in the traction converter according to the first embodiment of the present invention;
FIG. 6 is a cross-sectional view taken along B-B of FIG. 5;
FIG. 7 is a cross-sectional view taken along C-C of FIG. 5;
FIG. 8 is an enlarged view of D of FIG. 7;
FIG. 9 is an enlarged view of E of FIG. 3;
FIG. 10 is a cross-sectional view showing a state in which the traction converter according to the first embodiment of the present invention is mounted under the floor of a passenger compartment of a railway vehicle, as viewed in the vehicle running direction;
FIG. 11 is a side cross-sectional view of a cooler in Japanese Patent No. 4948625 (Patent Document 2);
FIG. 12 is a diagram showing a calculation result of the temperature distribution of a semiconductor element group to be mounted in the traction converter according to the first embodiment of the present invention;
FIG. 13 is a diagram showing a calculation result of the maximum temperature of the semiconductor element group to be mounted in the traction converter according to the first embodiment of the present invention;
FIG. 14 is a side cross-sectional view of a cooler to be mounted in a traction converter according to a second embodiment of the present invention;
FIG. 15 is a diagram showing a calculation result of the maximum temperature of a semiconductor element group to be mounted in the traction converter according to the second embodiment of the present invention, and the weight of the cooler;
FIG. 16 is a side cross-sectional view of a cooler to be mounted in a traction converter according to a third embodiment of the present invention;
FIG. 17 is a diagram showing a calculation result of the temperature distribution of a semiconductor element group to be mounted in the traction converter according to the third embodiment of the present invention;
FIG. 18 is a diagram showing a relation between a calculation result of the maximum temperature of the semiconductor element group to be mounted in the traction converter according to the third embodiment of the present invention and the weight of the cooler;
FIG. 19 is a side cross-sectional view of a cooler to be mounted in a traction converter according to a fourth embodiment of the present invention;
FIG. 20 is a side cross-sectional view of a cooler to be mounted in a traction converter according to a fifth embodiment of the present invention;
FIG. 21 is a side cross-sectional view of a cooler in Japanese Patent Laid-Open No. 2000-161880 (Patent Document 1);
FIG. 22 is a side cross-sectional view of the cooler in Japanese Patent Laid-Open No. 2000-161880 (Patent Document 1);
FIG. 23 is a diagram showing a calculation result of the temperature distribution of a semiconductor element group to be mounted in the traction converters according to the fourth embodiment and fifth embodiment of the present invention;
FIG. 24 is a diagram showing a relation between a calculation result of the maximum temperature of the semiconductor element group to be mounted in the traction converters according to the fourth embodiment and fifth embodiment of the present invention and the weight of the cooler;
FIG. 25 is a side cross-sectional view of a cooler to be mounted in a traction converter according to a sixth embodiment of the present invention;
FIG. 26 is a side cross-sectional view of a cooler to be mounted in a traction converter according to a seventh embodiment of the present invention; and
FIG. 27 is a side cross-sectional view of a cooler to be mounted in a traction converter according to an eighth embodiment of the present invention.

### DETAILED DESCRIPTION OF THE PREFERRED EMBODIMENTS

### [Embodiment 1]

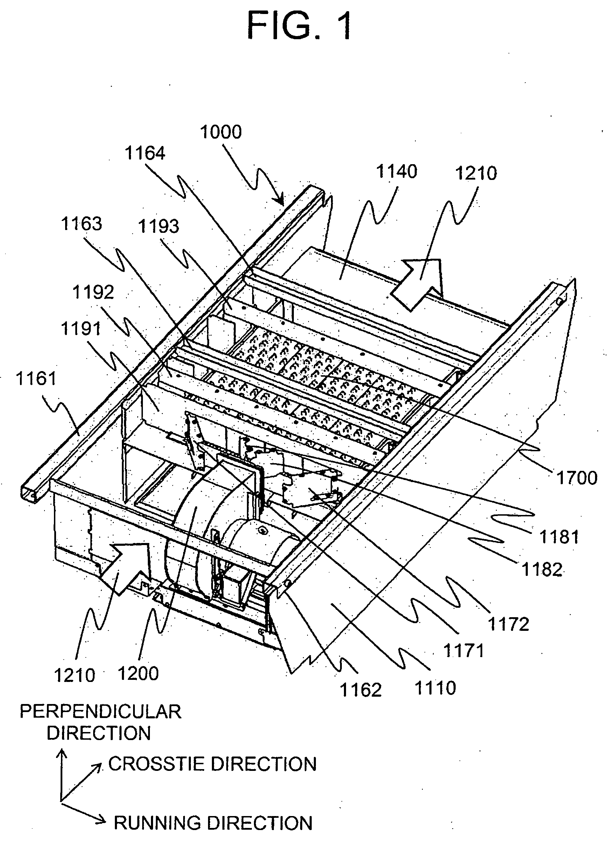

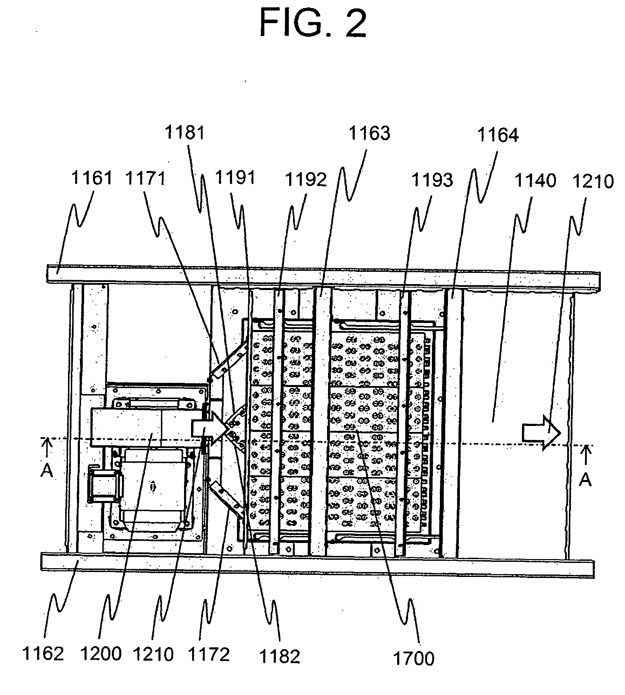

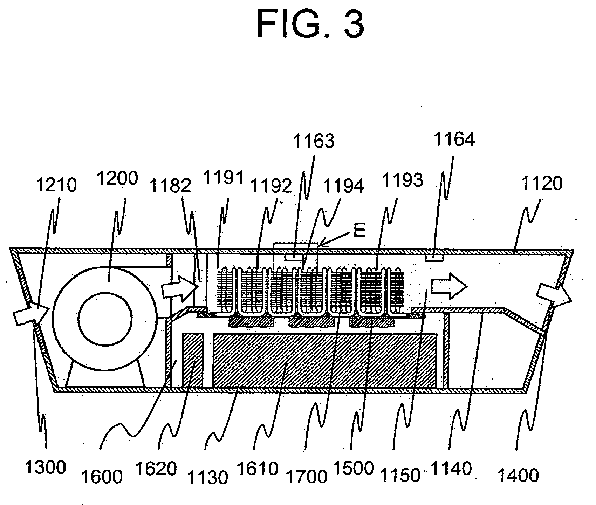

Hereinafter, a traction converter according to the present invention will be explained in detail with reference to the drawings. FIG. 1 illustrates a perspective view showing the overall configuration of a traction converter according to a first embodiment of the present invention, FIG. 2 illustrates a top view of FIG. 1 and FIG. 3 illustrates a cross-sectional view taken along A-A of FIG. 2.

A traction converter 1000 is configured by a side plate 1110, a top plate 1120 and a bottom plate 1130. On the top surface of the traction converter 1000, crosstie-directional beams 1161, 1162 and travel-directional beams 1163, 1164 are provided, and thereby the strength of the traction converter 1000 is kept. Between the top plate 1120 and the bottom plate 1130, a wind-passage bottom plate 1140 is provided. A space surrounded by the side plate 1110, the top plate 1120 and the wind-passage bottom plate 1140 is a wind passage 1150, and cooling wind 1210 flows in the wind passage 1150. Further, a space surrounded by the side plate 1110, the bottom plate 1130 and the wind-passage bottom pilate 1140 is a circuit component mounting space 1600, and a semiconductor element group 1500 constituting a main circuit of the traction converter 1000, a filter capacitor 1610, and a gate driver 1620 for controlling the switching of the semiconductor element group 1500 are provided therein.

The semiconductor element group 1500 in the circuit component mounting space 1600 is provided on the under surface of a cooler 1700. A heat receiving block 1710 of the cooler 1700 is connected with the under surface side of the wind-passage bottom plate 1140 in an air-tight manner, such that the cooling wind 1210 does not flow into the circuit component mounting space 1600.

On the other hand, the top surface side of the cooler 1700 is provided in the wind passage 1150. The cooler 1700 does not cohere to the side plate 1110 and the top plate 1120 so that a void is present. For reducing the volume of the cooling wind 1210 to pass through this void, plural wind-leak prevention plates 1191, 1192, 1193, 1194 are provided in the flow direction of the cooling wind, in the space around the cooler 1700. The orientation in which each of the wind-leak prevention plates 1191, 1192, 1193, 1194 is provided is the direction orthogonal to the flow of the cooling wind 1210. Further, the wind-leak prevention plate 1194 is provided so as to protrude downward from the travel-directional beam 1163.

A blower 1200 is provided such that the center of the supply opening is roughly on the central line of the cooler 1700. The cooling wind 1210 is drawn in the traction converter 1000 through a filter 1300, and is supplied from the supply opening of the blower 1200 to the cooler 1700. Here, the width of the supply opening of the blower 1200 is small compared to the width of the cooler 1700, and therefore, the wind passage 1150 is expanded to a similar width to the cooler 1700, by wind-passage expansion plates 1171, 1172. The wind-passage expansion plates 1171, 1172 are connected with the wind-leak prevention plate 1191 that is provided at the most up-wind side. Further, for uniformly supplying the cooling wind 1210 to the cooler 1700, two rectification plates 1181, 1182 are provided between the supply opening of the blower 1200 and the cooler 1700. These two rectification plates 1181, 1182 are provided so as to be symmetric with respect to the center of the supply opening of the blower 1200, and are provided such that the down-wind side is wider in void than the up-wind side. The cooling wind 1210 that has passed through the rectification plates 1181, 1182 and the cooler 1700 is exhausted from a grille 1400 to the exterior.

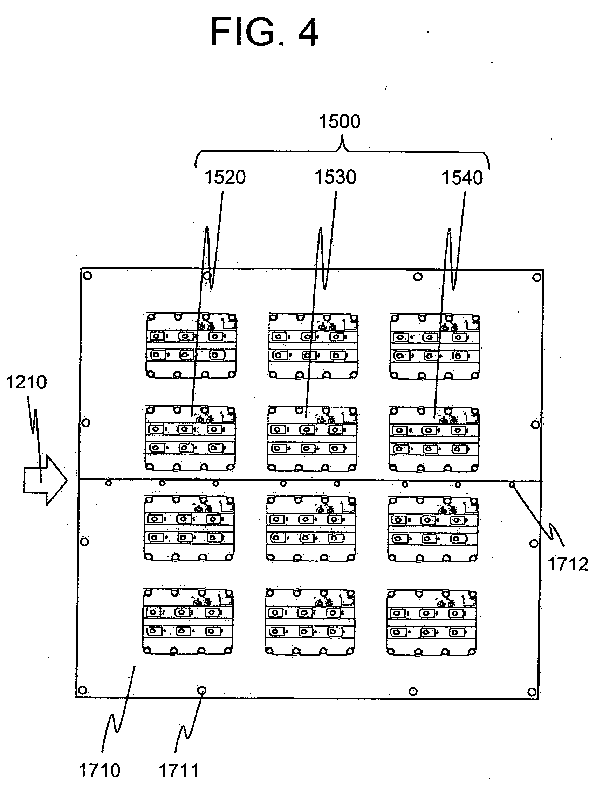

FIG. 4 illustrates a bottom view of the cooler and the semiconductor element group. The heat receiving block 1710, which is a component of the cooler 1700, is composed of two aluminum thick plates, and they are connected with each other by connecting bolts 1712. Further, the edge part of the heat receiving block 1710, at which plural cooler-fixation screw holes 1711 are opened, is connected with the wind-passage bottom plate 1140 described in FIG. 3. The semiconductor element group 1500 is arrayed on the under surface of the heat receiving block 1710. In the traction converter according to the first embodiment, three semiconductor elements are provided in the cooling wind flow direction, and four semiconductor elements are provided in the direction orthogonal to the cooling wind flow, so that the plural semiconductor elements constitute the semiconductor element group 1500. These semiconductor elements are denoted by reference numerals 1520, 1530 and 1540 from the up-wind side. The heat losses of the respective semiconductor elements are roughly equal.

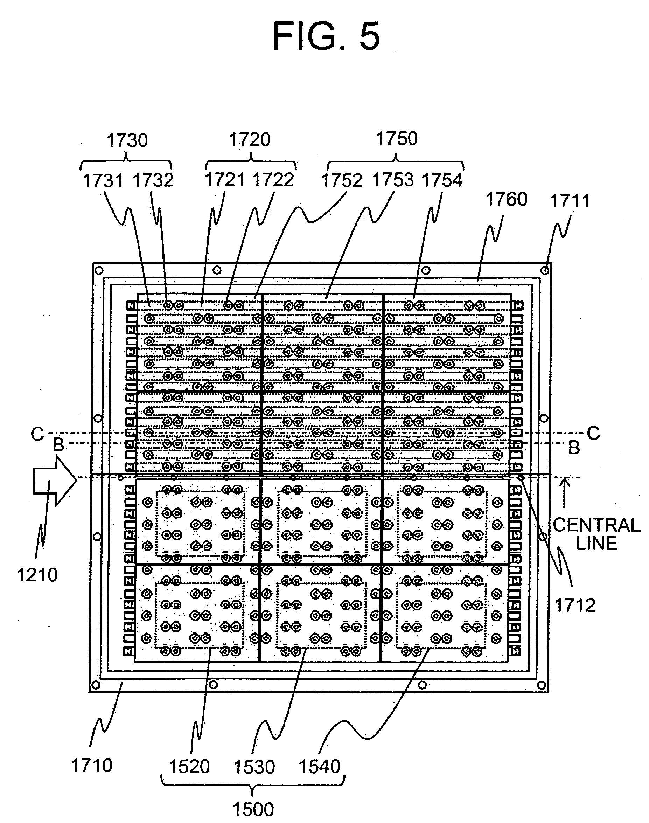

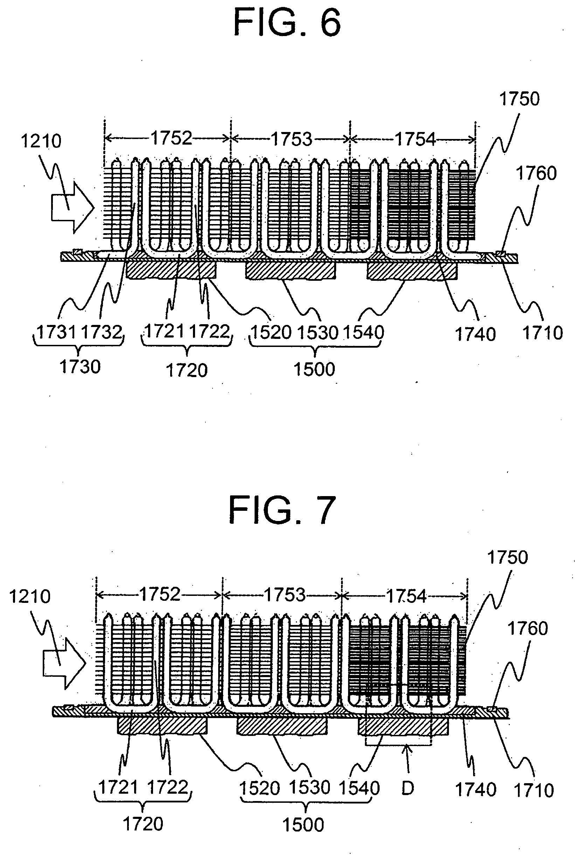

FIG. 5 illustrates a top view of the cooler, FIG. 6 illustrates a cross-sectional view taken along B-B of FIG. 5, and FIG. 7 illustrates a cross-sectional view taken along C-C of FIG. 5. In FIG. 5, the dotted lines illustrated on the upper side relative to the central line shows heat receiving parts of heat pipes, and the dotted lines illustrated on the lower side relative to the central line shows a projection view of the semiconductor element group 1500 provided on the under surface of the heat receiving block 1710. On the top surface side of the heat receiving block 1710, plural grooves are formed along the flow direction of the cooling wind 1210. On the grooves, heat receiving parts 1721 of plural U-shaped heat pipes 1720 and heat receiving parts 1731 of plural L-shaped heat pipes 1730 are provided along the flow direction of the cooling wind 1210, and a brazing material 1740 such as solder is put into the grooves and is hardened. Thereby, the U-shaped heat pipes 1720 and the L-shaped heat pipes 1730 are joined to the heat receiving block 1710. Further, heat radiation parts 1722 of the U-shaped heat pipes 1720 and heat radiation parts 1732 of the L-shaped heat pipes 1730 are erectly provided in the perpendicular direction, and plural heat radiation fins 1750 having through holes according to the positions of the heat radiation parts are press-fitted to each of the heat radiation parts 1722, 1732.

On the other hand, between the region at which the heat pipes are provided and the cooler-fixation screw holes 1711 on the top surface of the heat receiving block 1710, a seal material 1760 is provided along the entire circumference. Thereby, the wind-passage bottom plate 1140 and the cooler 1700 are connected such that the air tightness is kept.

The arrangement of the heat pipes will be explained. On the B-B cross-section shown in FIG. 6, as the heat pipes, an L-shaped heat pipe 1730, five U-shaped heat pipes 1720 and an L-shaped heat pipe 1730 are provided in this order, along the flow direction of the cooling wind 1210. On the C-C cross-section shown in FIG. 7, six U-shaped heat pipes 1720 are provided. As shown in FIG. 5, the heat pipe arrangement on the B-B cross-section and the heat pipe arrangement on the C-C cross-section are provided alternately, and thereby, the heat receiving parts 1721, 1731 of the heat pipes and the heat radiation parts 1722, 1732 of the heat pipes are arranged in a zigzag manner.

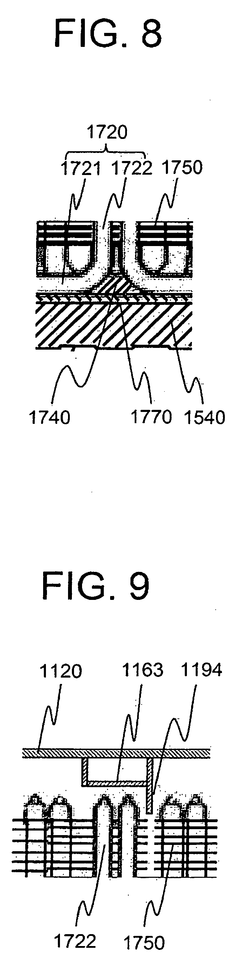

FIG. 8 illustrates an enlarged view of D of FIG. 7. In the heat receiving block 1710, a region just under the heat radiation part 1722 of the heat pipe is a region 1770 with no heat receiving part of the heat pipe, and has a high heat resistance compared to the interior of the heat receiving part of the heat pipe, leading to a fear that the temperature increases locally. As described above, the heat receiving parts 1721, 1731 of the heat pipes are arranged in a zigzag manner, and thereby, for example, the heat receiving part 1721 on the B-B cross-section is arranged at the vicinity of the region 1770 with no heat receiving part of the heat pipe on the C-C cross-section. Therefore, the heat transfer is promoted and the local temperature rise is inhibited.

The configuration of the heat radiation fins will be explained. In the first embodiment of the present invention, the heat radiation fins 1750 are divided into an up-wind region 1752, a mid-wind region 1753 and a down-wind region 1754, and the number of the heat radiation fins 1750 to be provided is 16 at the up-wind region 1752, 20 at the mid-wind region 1753 and 48 at the down-wind region 1754. That is, the surface area of the heat radiation fins 1750 at the up-wind region 1752 is 0.33 times of that at the down-wind region 1754, and the surface area of the heat radiation fins 1750 at the mid-wind region 1753 is 0.42 times of that at the down-wind region 1754. On the other hand, in consideration of productivity, the fins 1750 are divided into four in the direction orthogonal to the flow of the cooling wind 1210.

The positional relation between the cooler and the wind-leak prevention plate will be explained. FIG. 9 is an enlarged view of E of FIG. 3, and illustrates the positional relation between the pointed-end of the heat radiation part 1722 of the heat pipe and the wind-leak prevention plate 1194. The pointed-end of the heat radiation part 1722 of the heat pipe is small in diameter compared to the part except the pointed-end, and the heat radiation fins 1750 cannot be press-fitted. Therefore, the pointed-end of the heat radiation part 1722 of the heat pipe is protruded from the topmost fin by roughly 20 to 30 mm. On the other hand, the wind-leak prevention plate 1194 is provided at the position between the heat radiation parts 1722 of the heat pipe. The void between the wind-leak prevention plate 1194 and the topmost fin is roughly 5 mm, and is smaller than the void between the pointed-end of the heat radiation part 1722 of the heat pipe and the topmost fin.

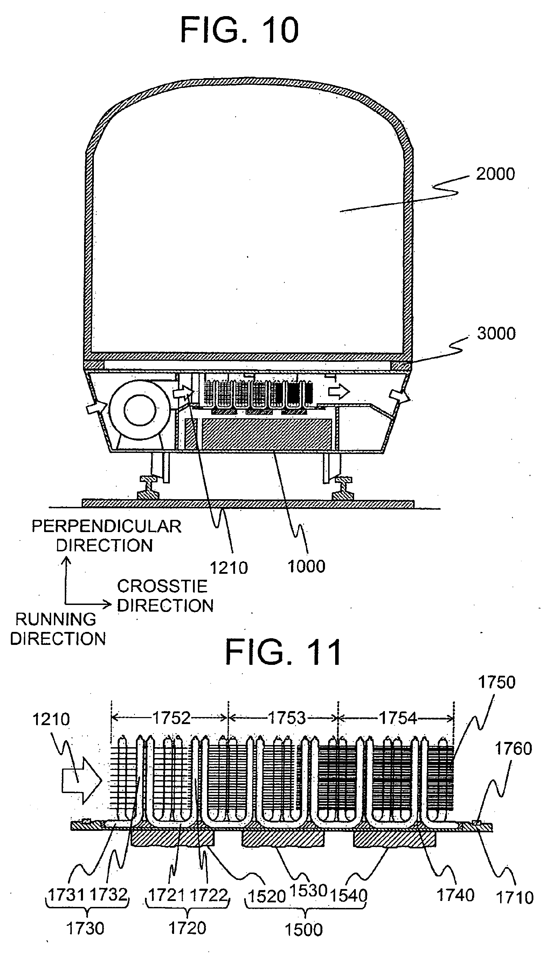

A state in which the traction converter is mounted under the floor of a passenger compartment of a railway vehicle will be explained. FIG. 10 illustrates a cross-sectional view as viewed in the vehicle running direction. The forward direction of the sheet shows the vehicle running direction, the lateral direction shows the crosstie direction, and the longitudinal direction shows the perpendicular direction. The traction converter 1000 is connected under the floor of a passenger compartment 2000 by a suspending member 3000. The cooling wind 1210 flows through the interior of the traction converter 1000 in the crosstie direction.

Next, the effect of the first embodiment of the present invention will be explained. The plural heat radiation fins 1750 are divided in the flow direction of the cooling wind 1210, and the surface area of the heat radiation fins at the up-wind region 1752 and mid-wind region 1753, at which the temperature of the cooling wind 1210 is low, is smaller than that at the down-wind region 1754, at which the temperature of the cooling wind rises, that is, the numbers of the heat radiation fins are less than that at the down-wind region, and the surface areas of the heat radiation fins at the respective regions are set such that the respective temperatures of the semiconductor element group 1500 are equalized. Thereby, it is possible to efficiently cool the semiconductor element group 1500 in the lightweight device configuration.

Further, the heat receiving part 1721 of the U-shaped heat pipe 1720 is provided in the direction along the flow of the cooling wind 1210, and thereby, the heat transfer can be promoted through the heat receiving part 1721, from the down-wind side to the up-wind side for the cooling wind 1210. Therefore, it is possible to perform the leveling of the influence of the temperature rise of the cooling wind, and to inhibit the temperature rise of the semiconductor elements at the down-wind side. Further, the heat radiation part 1722 of the U-shaped heat pipe 1720 is provided so as to be erectly provided in the vertical direction, and the plural heat radiation fins 1750 are provided in the wind passage 1150 while being joined to the heat radiation part 1722. Thereby, it is possible to promote the heat transfer from the heat receiving block 1710 to the heat radiation fin 1750, resulting in an improvement of the fin efficiency.

Further, the heat radiation parts 1722 of the U-shaped heat pipes 1720 are provided in a zigzag manner. Thereby, the joining parts of the heat radiation fins 1750 and the heat pipes are equally arranged, and the heat is equally transported to the heat radiation fins 1750, resulting in an improvement of the fin efficiency. Moreover, the cross-sectional area of the passage between the heat radiation fins and the cross-sectional area of the passage between the heat pipes are large compared to the case where the heat radiation parts of the heat pipes are arranged in a square manner. Therefore, the ventilation resistance between the heat radiation fins is reduced, and a lot of cooling wind 1210 can be supplied when the cooling is performed using the blower 1200, allowing for an efficient cooling of the semiconductor element group 1500.

Further, the L-shaped heat pipe 1730 is provided at the position of the most up-wind side, at the position of the most down-wind side, or at both of the up-wind side and down-wind side, and thereby, the heat receiving part 1731 of the L-shaped heat pipe 1730 can be provided outside the projection plane of the heat radiation fins 1750. Thereby, even if the semiconductor element group 1500 is provided outside the projection plane of the fins 1750, the heat can be efficiently transported to the heat radiation fins 1750 by the L-shaped heat pipe 1730, allowing for a downsizing and light-weighting of the heat radiation fins 1750.

Further, in the wind passage 1150, the plural rectification plates 1181, 1182 are provided at the up-wind side to the fins 1750, and thereby, the wind speed of the cooling wind 1210 to be supplied from the blower 1200 to the heat radiation fins 1750 can be equalized in the direction orthogonal to the flow of the cooling wind 1210. Therefore, even if the width of the heat radiation fins 1750 is large relative to the width of the supply opening of the blower 1200, the semiconductor element group 1500 can be efficiently cooled.

Further, in the wind passage 1150, the plural wind-leak prevention plates 1191, 1192, 1193, 1194 are provided in the direction orthogonal to the flow of the cooling wind 1210, between the heat radiation fin joined to the extreme pointed-end side of the heat radiation part 1722 of the heat pipe and the top plate 1130 configuring the wind passage 1150, and thereby, it is possible to prevent the cooling wind 1210 from leaking from between the heat radiation fins. Therefore, the semiconductor element group 1500 can be efficiently cooled. Moreover, the distance between the plural wind-leak prevention plates 1191, 1192, 1193, 1194 and the heat radiation fin 1750 joined to the pointed-end side of the heat radiation part 1722 of the heat pipe is shorter than the distance between the heat radiation fin 1750 joined to the pointed-end side and the pointed-end of the heat radiation part 1722 of the heat pipe. Thereby, it is possible to further reduce the volume of the cooling wind 1210 to leak from between the heat radiation fins.

Further, the wind-leak prevention plate 1194 serves also as the beam 1163 for keeping the strength in the wind passage 1150. Thereby, it is possible to decrease the number of components, and therefore, to achieve a cost reduction and an improvement of ease of assembly.

By the configuration, it is possible to efficiently cool the semiconductor element group 1500 by equalizing the temperature, and to mount the traction converter 1000 including the lightweight cooler, in a railway vehicle.

Next, a conventional art will be explained as a comparison to the first embodiment of the present invention. FIG. 11 illustrates the cooler described in Japanese Patent No. 4948625 (Patent Document 2). In the cooler described in Japanese Patent No. 4948625 (Patent Document 2), as described above, of the plural heat radiation fin groups, the heat radiation fin group arranged at the up-wind side of the cooling wind has a larger fin pitch than the fin pitch of the heat radiation fin group arranged at the down-wind side of the cooling wind. Further, assuming that the heat radiation fin groups constitute a single heat radiation fin group that is formed by a plurality of single-fins extending from the up-wind to the down-wind, the positions of the group gaps between the plural heat radiation fin groups are positions of the surface temperature of the heat radiation fin of the single heat radiation fin group at which the temperature difference between the up-wind and down-wind of the fin surface of the single heat radiation fin group is evenly divided by the number of the plural heat radiation fin groups.

Here, the relation between the temperature distribution of the surface of the heat radiation fin 1750 and the distance from the edge of the heat radiation fin is not linear. The closer to the up-wind side, the more drastically the temperature rises, and as going to the down-wind side, the temperature rises asymptotically to the maximum surface temperature of the heat radiation fin 1750. Therefore, the positions of the group gaps of the heat radiation fins 1750 are at a more up-wind side than positions at which the region for providing the heat radiation fins 1750 is evenly divided into three.

In the cooler described in FIG. 11, the number of the heat radiation fins 1750 is 12 at the up-wind side, 24 at the mid-wind side, and 48 at the down-wind side. The surface area of the heat radiation fins 1750 at the up-wind region 1752 is 0.34 times of that at the down-wind region 1754, and the surface area of the heat radiation fins 1750 at the mid-wind region 1753 is 0.69 times of that at the down-wind region 1754.

Next, for examining the effect of the first embodiment of the present invention, the temperatures of the respective semiconductor elements were calculated using generic thermal fluid analysis software. In the calculation, the heat radiation fin surface area at the down-wind region 1754 was set to a constant, and the heat radiation fin surface areas at the up-wind region 1752 and mid-wind region 1753 were changed for comparison. Further, the heat losses of the respective semiconductor elements of the semiconductor element group 1500 were set to a constant, and the change in pressure loss and cooling wind volume caused by the change in the number of the heat radiation fins 1750 was considered.

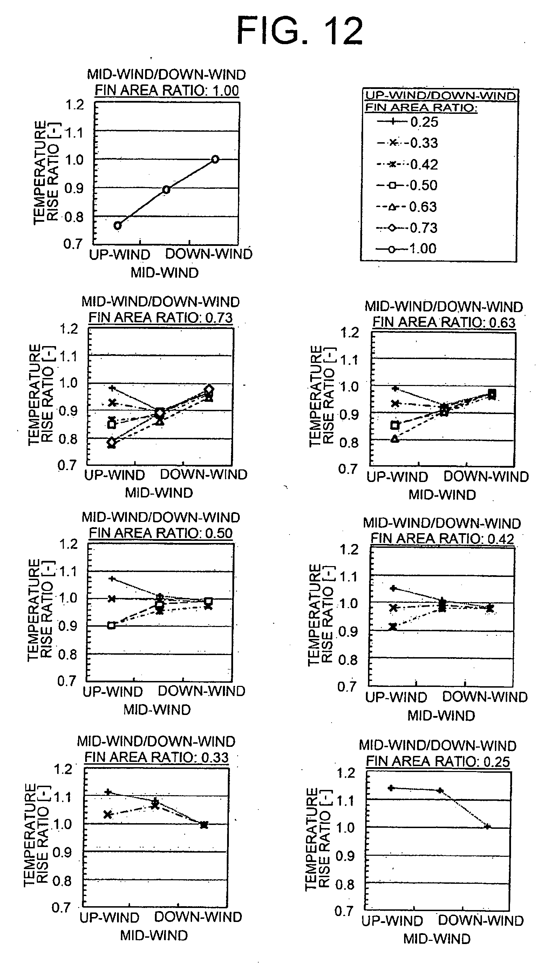

FIG. 12 illustrates changes in the temperature rises for the up-wind semiconductor element 1520, mid-wind semiconductor element 1530 and down-wind semiconductor element 1540 when the surface areas of the heat radiation fins at the up-wind region 1752 and mid-wind region 1753 are changed, which were calculated by the generic thermal fluid analysis software. The temperature rise ratio of the vertical axis in the graph is a relative value when the mid-wind/down-wind fin surface area ratio and the up-wind/down-wind fin surface area ratio are 1.00 and the temperature rise for the semiconductor element 1540 at the down-wind region is 1.00. According to this, when the mid-wind/down-wind fin surface area ratio and the up-wind/down-wind fin surface area ratio are 1.00, the temperature rise ratio for the semiconductor element 1530 at the mid-wind region is 0.89 and the temperature rise ratio for the semiconductor element 1520 at the up-wind region is 0.77, relative to the semiconductor element 1540 at the down-wind region. Thus, there is a temperature dispersion of 23%. In contrast, when the mid-wind/down-wind fin surface area ratio is 0.50 or 0.42 and the up-wind/down-wind fin surface area ratio is 0.33, the temperatures of the respective semiconductor elements are equalized.

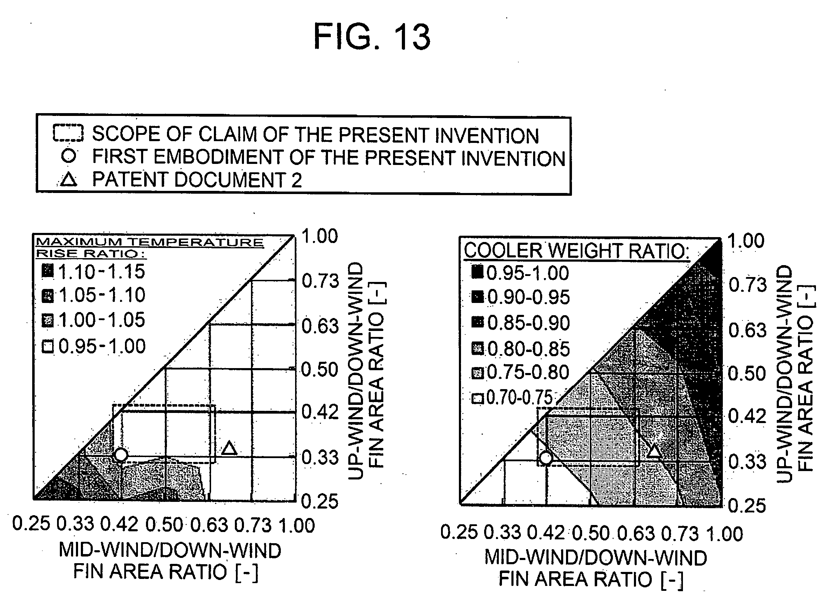

FIG. 13 illustrates the maximum temperature rise ratio for the semiconductor element group 1500 and the cooler weight ratio when the heat radiation fin surface areas at the up-wind region 1752 and mid-wind region 1753 are changed, which were calculated by the generic thermal fluid analysis software. The maximum temperature rise ratio and the cooler weight ratio are relative values when the mid-wind/down-wind fin surface area ratio and the up-wind/down-wind fin surface area ratio are 1.00 and the temperature rise for the semiconductor element group 1500 and the cooler weight ratio are 1.00. The magnitudes of the values are shown by the shade of color. According to this, it is shown that, compared to the case where the mid-wind/down-wind fin surface area ratio and the up-wind/down-wind fin surface area ratio are 1.00, the maximum temperature rise ratio is equivalent or less in a region in which the up-wind/down-wind fin surface area ratio is 0.33 or more and the mid-wind/down-wind fin surface area ratio is 0.42 or more. Particularly, in the first embodiment of the present invention, the up-wind/down-wind fin surface area ratio is 0.33, the mid-wind/down-wind fin surface are ratio is 0.42 and the cooler weight is 0.74, and therefore it is shown that the present invention allows for a light-weighting of 26% while having an equivalent cooling performance. Further, the region surrounded by the dotted line in FIG. 13 is the region in which the up-wind/down-wind fin surface area ratio is 0.33 to 0.42 and the mid-wind/down-wind fin surface area ratio is 0.42 to 0.63, and shows the scope of the claim of the present invention. Thereby, it is shown that a traction converter in the scope of the claim of the present invention is more lightweight while having a cooling performance equivalent to Japanese Patent No. 4948625 (Patent Document 2).

### [Embodiment 2]

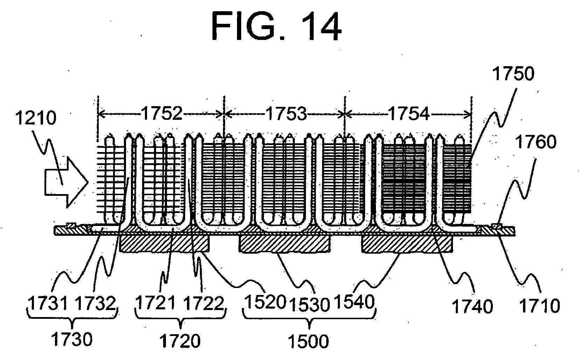

FIG. 14 illustrates a side cross-sectional view of a cooler to be mounted in a traction converter according to a second embodiment of the present invention. In the first embodiment, the positions of the division points of the heat radiation fins in the cooling wind flow direction are fixed, the number of the heat radiation fins is changed, and thereby the heat radiation fin surface areas at the up-wind region 1752, mid-wind region 1753 and down-wind region 1754 are changed. However, it is allowable that the positions of the division points of the heat radiation fins in the cooling wind flow direction are changed, and thereby the heat radiation fin surface areas are changed. In the second embodiment, the number of the heat radiation fins 1750 is 12, 24 and 48 from the up-wind side, and the fin pitch ratio is 4 : 2 : 1. The boundary between the region at which the number of the heat radiation fins is 12 and the region at which it is 24 is placed at a more up-wind side than the position when the region for providing the heat radiation fins is evenly divided into three, and further the boundary between the region at which the number of the heat radiation fins is 24 and the region at which it is 48 is placed at a more down-wind side than the position when the region for providing the heat radiation fins is evenly divided into three, such that the surface area of the heat radiation fins 1750 at the up-wind region 1752 is 0.35 times of that at the down-wind region 1754 and the surface area of the heat radiation fins 1750 at the mid-wind region 1753 is 0.53 times of that at the down-wind region 1754. Here, in Japanese Patent No. 4948625 (Patent Document 2), as described above, the positions of the group gaps between the heat radiation fins 1750 are at a more up-wind side than the positions when the region for providing the heat radiation fins 1750 is evenly divided into three, and therefore, the second embodiment of the present invention and Japanese Patent No. 4948625 (Patent Document 2) are distinctly different in the configuration of the cooler.

In the second embodiment of the present invention, since the heat radiation fin pitches at the respective regions have integral ratios, the ventilation resistances between the heat radiation fins are equal, and therefore the flow volume of the cooling wind can be equalized. In addition, the ventilation resistances can be decreased, and therefore the volume of the cooling wind from the blower is increased, allowing for an efficient cooling.

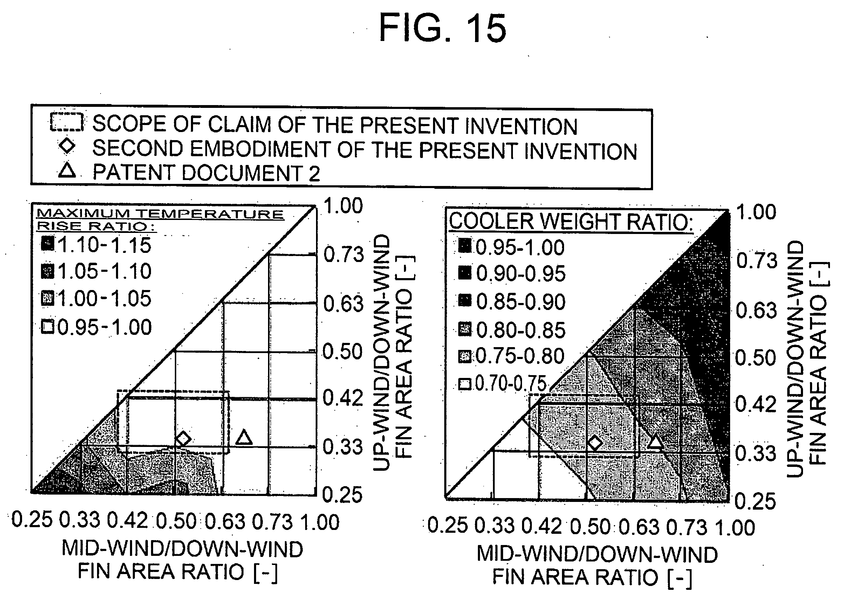

For examining the effect of the second embodiment of the present invention, the maximum temperature rise for the semiconductor element group was calculated using the generic thermal fluid analysis software. FIG. 15 illustrates the maximum temperature rise ratio for the semiconductor element group 1500 and the cooler weight ratio when the heat radiation fin surface areas at the up-wind region 1752 and mid-wind region 1753 are changed, which were calculated by the generic thermal fluid analysis software. According to this, it is shown that in the second embodiment of the present invention, compared to the case where the mid-wind/down-wind fin surface area ratio and the up-wind/down-wind fin surface area ratio are 1.00, the maximum temperature rise ratio is roughly equivalent and the cooler weight is 0.75, and that the present invention allows for a light-weighting of 25% while having an equivalent cooling performance. Further, it is shown that the traction converter is lightweight while having an equivalent cooling performance compared to Japanese Patent No. 4948625 (Patent Document 2).

### [Embodiment 3]

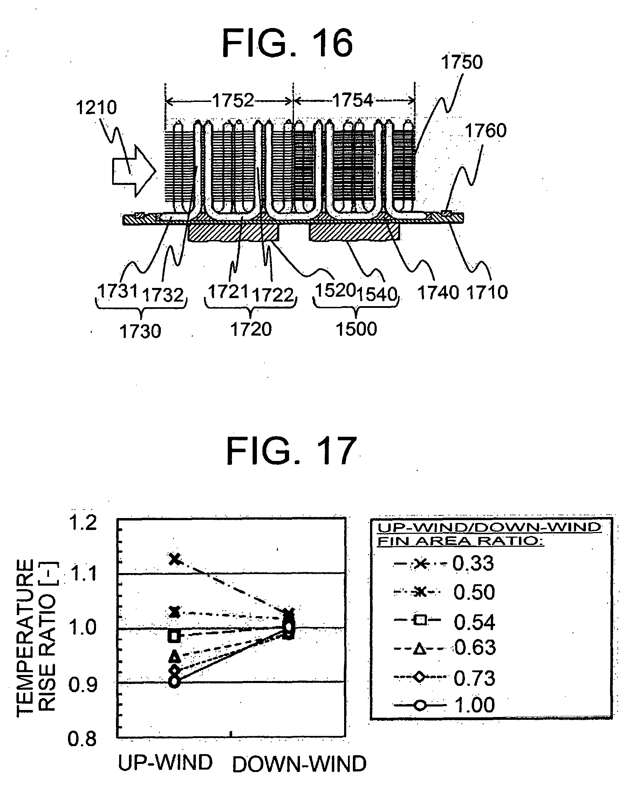

FIG. 16 illustrates a side cross-sectional view of a cooler to be mounted in a traction converter according to a third embodiment of the present invention. The third embodiment has a configuration in which two semiconductor element groups 1500 are provided in the cooling wind flow direction, and the region for providing the plural heat radiation fins is divided in the cooling wind flow direction into two: an up-wind region 1752 and a down-wind region 1754. The number of the heat radiation fins 1750 to be provided is 26 at the up-wind region 1752 and 48 at the down-wind region 1754. That is, the surface area of the heat radiation fins 1750 at the up-wind region 1752 is 0.54 times of that at the down-wind region 1754.

In the configuration in which the two semiconductor element groups 1500 are provided in the cooling wind flow direction as the third embodiment of the present invention, the plural heat radiation fins 1750 are divided into two in the flow direction of the cooling wind 1210, and the heat radiation fin area at the up-wind region 1752, at which the temperature of the cooling wind 1210 is low, is smaller than that at the down-wind region 1754, at which the temperature of the cooling wind rises, that is, the number of the heat radiation fins is less than that at the down-wind region, and the heat radiation fin areas at the respective regions are set such that the temperatures of the respective semiconductor element groups 1500 are equalized. Thereby, it is possible to efficiently cool the semiconductor element groups 1500 in the lightweight device configuration.

For examining the effect of the third embodiment of the present invention, the temperatures of the respective semiconductor elements were calculated using the generic thermal fluid analysis software. FIG. 17 illustrates changes in the temperature rises for the semiconductor element 1520 at the up-wind region and the semiconductor element 1540 at the down-wind region when the heat radiation fin surface area at the up-wind region 1752 is changed, which were calculated by the generic thermal fluid analysis software. According to this, when the up-wind/down-wind fin surface area ratio is 1.00, the temperature rise ratio for the semiconductor element 1540 at the down-wind region is 1.00 while the temperature rise ratio for the semiconductor element 1520 at the up-wind region is 0.90, and there is a temperature dispersion of 10%. In contrast, when the up-wind/down-wind fin surface area ratio is 0.54, the temperatures of the respective semiconductor elements are equalized. On the other hand, when the up-wind/down-wind fin surface area ratio is 0.50 or less, the temperature of the semiconductor element 1520 at the up-wind region is higher than that of the semiconductor element 1540 at the down-wind region.

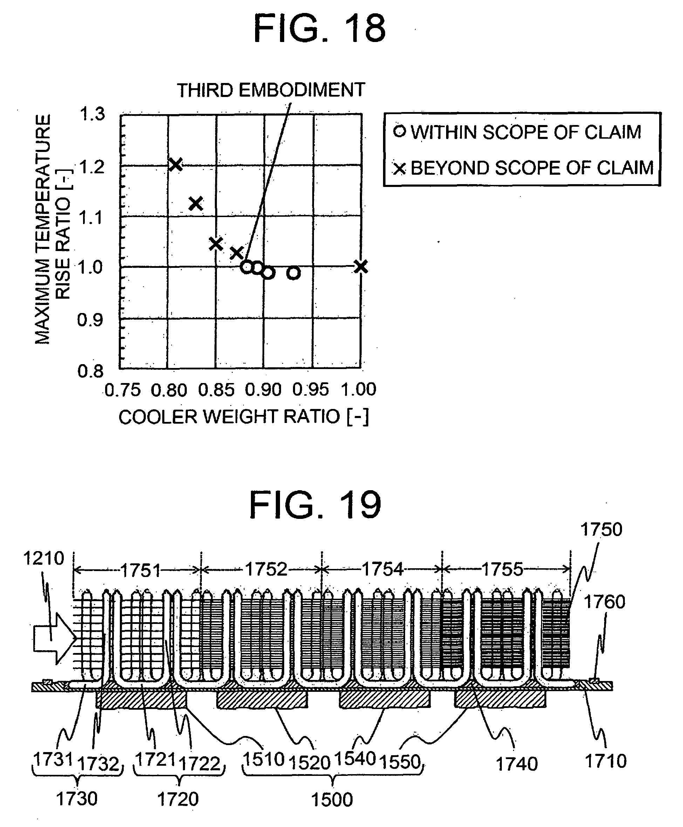

FIG. 18 illustrates the maximum temperature rise ratio for the semiconductor element group 1500 and the cooler weight ratio when the heat radiation fin area at the up-wind region 1752 is changed, which was calculated by the generic thermal fluid analysis software. In the scope of the claim of the present invention, the heat radiation fin surface area at the up-wind region is 0.54 to 0.73 times of the heat radiation fin surface area at the down-wind region, and it is shown that in the scope, the maximum temperature rise ratio is equivalent or less compared to the case where the up-wind/down-wind fin surface area ratio is 1.00. Particularly, in the third embodiment of the present invention, the up-wind/down-wind fin area ratio is 0.54 and the cooler weight ratio is 0.88, and therefore it is shown that the present invention allows for a light-weighting of 12% while having an equivalent cooling performance.

### [Embodiment 4]

FIG. 19 illustrates a side cross-sectional view of a cooler to be mounted in a traction converter according to a fourth embodiment of the present invention. The fourth embodiment has a configuration in which four semiconductor element groups 1500 are provided in the cooling wind flow direction, and the region for providing the plural heat radiation fins is divided in the cooling wind flow direction into four: a most up-wind region 1751, an up-wind region 1752, a down-wind region 1754 and a most down-wind region 1755. The number of the heat radiation fins 1750 to be provided is 24 at the most up-wind region 1751, 30 at the upwind region 1752, 35 at the down-wind region 1754 and 48 at the most down-wind region 1755. That is, the surface area of the heat radiation fins 1750 at the most up-wind region 1751 is 0.42 times of that at the most down-wind region 1755, the surface area of the heat radiation fins 1750 at the up-wind region 1752 is 0.63 times of that at the most down-wind region 1755, and the surface area of the heat radiation fins 1750 at the down-wind region 1754 is 0.73 times of that at the most down-wind region 1755. The effect of the fourth embodiment will be explained together with the effect of a fifth embodiment described later.

### [Embodiment 5]

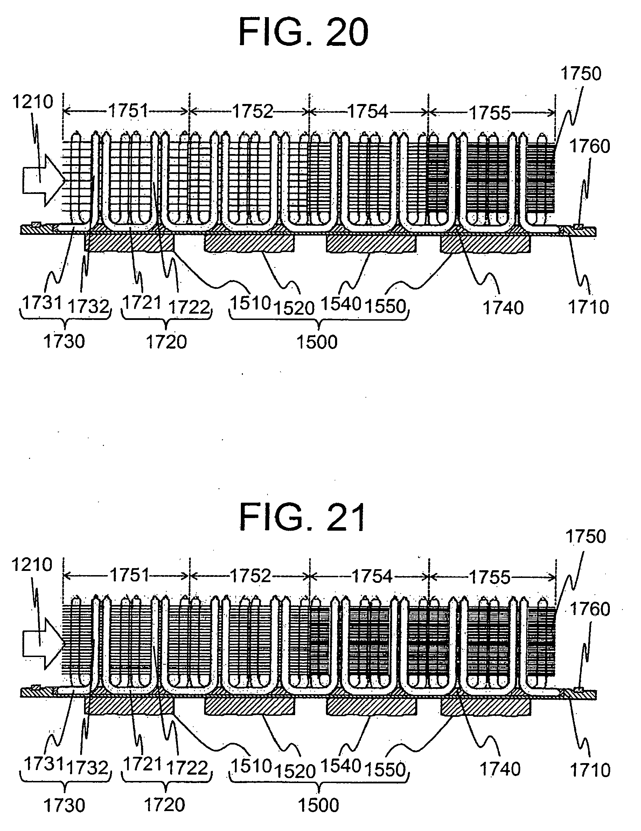

FIG. 20 illustrates a side cross-sectional view of a cooler to be mounted in a traction converter according to a fifth embodiment of the present invention. Similarly to the fourth embodiment, the fifth embodiment has a configuration in which four semiconductor element groups 1500 are provided in the cooling wind flow direction, and the region for providing the plural heat radiation fins is divided in the cooling wind flow direction into four: a most up-wind region 1751, an up-wind region 1752, a down-wind region 1754 and a most down-wind region 1755. In the fifth embodiment, the number of the heat radiation fins 1750 to be provided is 10 at the most up-wind region 1751, 12 at the up-wind region 1752, 20 at the down-wind region 1754 and 48 at the most down-wind region 1755. That is, the surface area of the heat radiation fins 1750 at the most up-wind region 1751 is 0.21 times of that at the most down-wind region 1755, the surface area of the heat radiation fins 1750 at the up-wind region 1752 is 0.25 times of that at the most down-wind region 1755, and the surface area of the heat radiation fins 1750 at the down-wind region 1754 is 0.42 times of that at the most down-wind region 1755.

In the configuration in which the four semiconductor element groups 1500 are provided in the cooling wind flow direction as the fourth embodiment and fifth embodiment of the present invention, the plural heat radiation fins 1750 are divided into four in the flow direction of the cooling wind 1210, and the heat radiation fin surface areas at the most up-wind region 1751, up-wind region 1752, down-wind region 1754, at which the temperature of the cooling wind 1210 is low, are smaller than that at the most down-wind region 1755, at which the temperature of the cooling wind rises, that is, the numbers of the heat radiation fins are less than that at the most down-wind region, and the heat radiation fin surface areas at the respective regions are set such that the temperatures of the semiconductor element groups 1500 are equalized. Thereby, it is possible to efficiently cool the semiconductor element group 1500 in the lightweight device configuration.

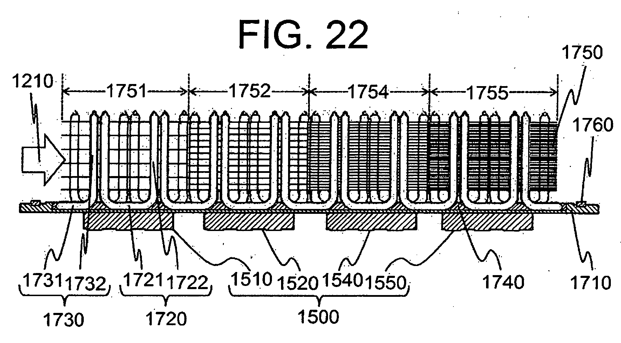

Next, a conventional art will be explained as a comparison to the fourth embodiment and fifth embodiment of the present invention. FIG. 21 and FIG. 22 illustrate coolers in Japanese Patent Laid-Open No. 2000-161880 (Patent Document 1). The coolers described in Japanese Patent Laid-Open No. 2000-161880 (Patent Document 1) have configurations in which four semiconductor element groups 1500 are provided in the cooling wind flow direction, and, in FIG. 21, the surface area of the heat radiation fins 1750 at the most up-wind region 1751 is 0.50 times of that at the most down-wind region 1755, the surface area of the heat radiation fins 1750 at the up-wind region 1752 is 0.50 times of that at the most down-wind region 1755, and the surface area of the heat radiation fins 1750 at the down-wind region 1754 is 1.00 times of that at the most down-wind region 1755. Further, in FIG. 22, the surface area of the heat radiation fins 1750 at the most up-wind region 1751 is 0.13 times of that at the most down-wind region 1755, the surface area of the heat radiation fins 1750 at the up-wind region 1752 is 0.25 times of that at the most down-wind region 1755, and the surface area of the heat radiation fins 1750 at the down-wind region 1754 is 0.50 times of that at the most down-wind region 1755.

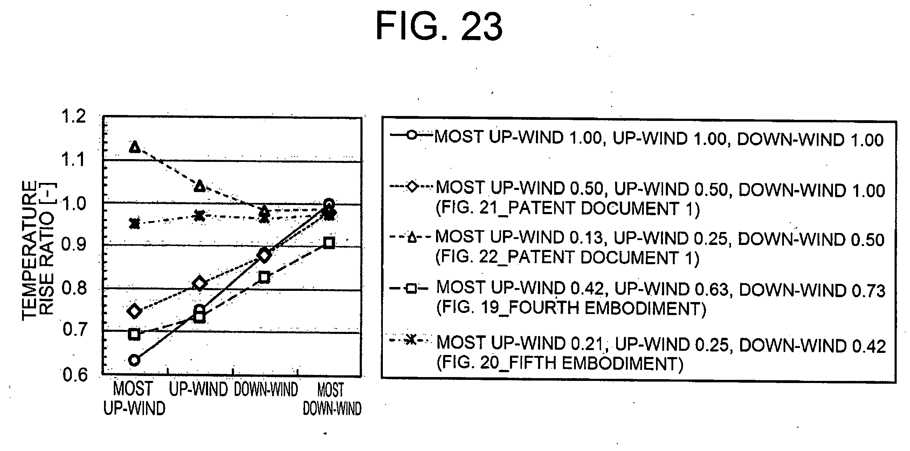

For examining the effect of the fourth embodiment and fifth embodiment of the present invention, the temperatures of the respective semiconductor elements were calculated using the generic thermal fluid analysis software. FIG. 23 illustrates changes in the temperature rises for the semiconductor element 1510 at the most up-wind region, the semiconductor element 1520 at the up-wind region, the semiconductor element 1540 at the down-wind region and the semiconductor element 1550 at the most down-wind region when the heat radiation fin areas at the most up-wind region 1751, the up-wind region 1752 and the down-wind region 1754 are changed, which were calculated by the generic thermal fluid analysis software. According to this, when all the fin surface area ratios for the respective regions are 1.00, the temperature rise ratio for the semiconductor element 1550 at the most down-wind region is 1.00, while the temperature rise ratio for the semiconductor element 1510 at the most up-wind region is 0.63, the temperature rise ratio for the semiconductor element 1520 at the up-wind region is 0.75 and the temperature rise ratio for the semiconductor element 1540 at the down-wind region is 0.88. Thus, there is a temperature dispersion of 37%. As for the cooler shown in FIG. 21, which is described in Japanese Patent Laid-Open No. 2000-161880 (Patent Document 1), the temperature rise ratio for the semiconductor element 1510 at the most up-wind region is 0.75, the temperature rise ratio for the semiconductor element 1520 at the up-wind region is 0.81, the temperature rise ratio for the semiconductor element 1540 at the down-wind region is 0.88 and the temperature rise ratio for the semiconductor element 1550 at the most down-wind region is 0.98. Thus, there is a temperature dispersion of 25%, and therefore, it can be said that there is room for light-weighting. Further, as for the cooler shown in FIG. 22, which is described in Japanese Patent Laid-Open No. 2000-161880 (Patent Document 1), the temperature rise ratio for the semiconductor element 1510 at the most up-wind region is 1.13, the temperature rise ratio for the semiconductor element 1520 at the up-wind region is 1.04, the temperature rise ratio for the semiconductor element 1540 at the down-wind region is 0.98, and the temperature rise ratio for the semiconductor element 1550 at the most down-wind region is 0.99. The temperature of the semiconductor element 1510 at the most up-wind region is higher than that of the semiconductor element 1550 at the most down-wind region, resulting in an inefficient cooling.

In contrast, as for the fourth embodiment of the present invention, the temperature rise ratio for the semiconductor element 1510 at the most up-wind region is 0.69, the temperature rise ratio for the semiconductor element 1520 at the up-wind region is 0.73, the temperature rise ratio for the semiconductor element 1540 at the down-wind region is 0.83 and the temperature rise ratio for the semiconductor element 1550 at the most down-wind region is 0.91. Although there is a temperature dispersion of 22%, the temperature rise ratio for the semiconductor element 1550 at the most up-wind region decreases by 9% compared to the case where all the fin area ratios for the respective regions are 1.00. This is because the number of the heat radiation fins 1750 at the most up-wind region 1751, up-wind region 1752 and down-wind region 1754 is reduced, and thereby, the pressure loss decreases and the volume of the cooling wind to be supplied from the blower increases so that the temperature decreases as a whole.

Further, as for the fifth embodiment of the present invention, the temperature rise ratio for the semiconductor element 1510 at the most up-wind region is 0.95, and the temperature rise ratios for the semiconductor element 1520 at the up-wind region, the semiconductor element 1540 at the down-wind region and the semiconductor element 1550 at the most down-wind region are 0.97. Thus, the temperatures of the respective semiconductor elements are equalized.

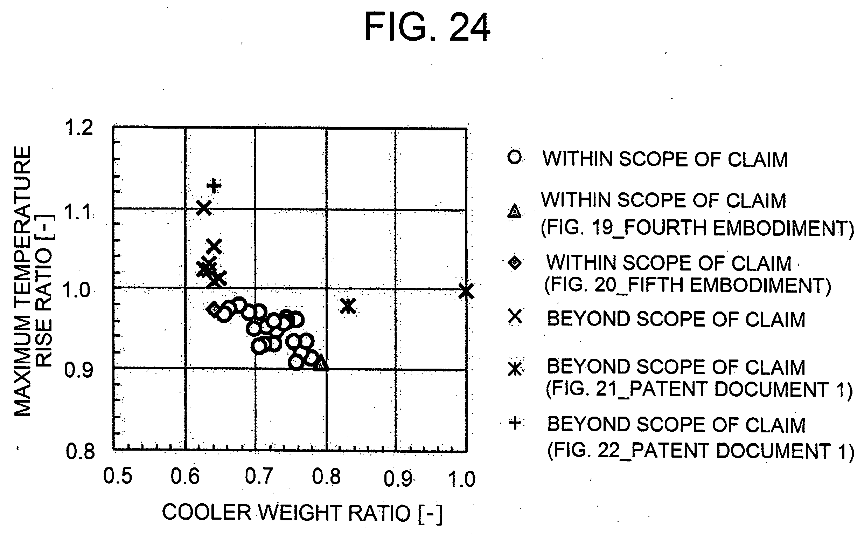

FIG. 24 illustrates the maximum temperature rise ratio for the semiconductor element group 1500 and the cooler weight ratio when the heat radiation fin areas other than the most down-wind region 1755 are changed in a range of 0.13 to 1.00, which were calculated by the generic thermal fluid analysis software. In the scope of the claim of the present invention, the heat radiation fin surface area at the most up-wind region is 0.21 to 0.42 times of the heat radiation fin surface area at the most down-wind region, the heat radiation fin surface area at the up-wind region is 0.25 to 0.63 times of the heat radiation fin surface area at the most down-wind region and the heat radiation fin surface area at the down-wind region is 0.42 to 0.73 times of the heat radiation fin surface area at the most down-wind region. It is shown that traction converters in the scope are in the lower left of the graph, that is, in a region in which both the cooler weight ratio and the heat resistance ratio are small, and can efficiently cool the semiconductor element groups in the lightweight cooler configurations.

Here, the cooler according to the fifth embodiment of the present invention is larger in temperature rise ratio by 6% but is smaller in cooler weight ratio by 15% than the cooler according to the fourth embodiment. Therefore, it is allowable to adopt the form shown in the fourth embodiment in the case of reducing the temperature rise preferentially, and adopt the form shown in the fifth embodiment in the case of reducing the cooler weight preferentially, and it is desirable to perform an appropriate selection depending on the required performance.

### [Embodiment 6]

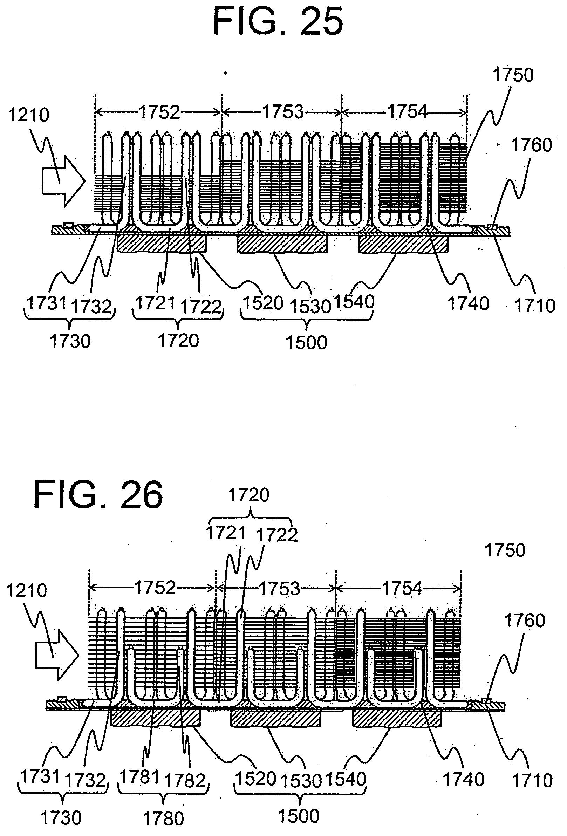

FIG. 25 illustrates a side cross-sectional view of a cooler to be mounted in a traction converter according to a sixth embodiment of the present invention. In the sixth embodiment of the present invention, the heat radiation fins 1750 are divided into an up-wind region 1752, a mid-wind region 1753 and a down-wind region 1754, and the number of the heat radiation fins 1750 to be provided is 16 at the up-wind region 1752, 20 at the mid-wind region 1753 and 48 at the down-wind region 1754. They are provided such that the topmost heat radiation fin at the up-wind region 1752 is at a lower position than the topmost heat radiation fin at the mid-wind region 1753, and the topmost heat radiation fin at the mid-wind region 1753 is at a lower position than the topmost head radiation fin at the down-wind region 1754.

By such a configuration, some of the cooling wind 1210 is supplied to the down-wind region 1754 without receiving the heat at the up-wind region 1752 and mid-wind region 1753, and thereby, it is possible to inhibit the temperature rise of the semiconductor element 1540 at the down-wind region and to cool it efficiently.

### [Embodiment 7]

FIG. 26 illustrates a side cross-sectional view of a cooler to be mounted in a traction converter according to a seventh embodiment of the present invention. In the seventh embodiment of the present invention, short-length heat pipes 1780, which are shorter in the length of the heat radiation part than the U-shaped heat pipes 1720 and the L-shaped heat pipes 1730, are partially provided. In FIG. 26, the L-shaped heat pipe 1730, the short-length heat pipe 1780, the U-shaped heat pipe 1720, the short-length heat pipe 1780, the U-shaped heat pipe 1720, the short-length heat pipe 1780 and the L-shaped heat pipe 1730 are provided in this order.

The heat radiation part 1782 of the short-length heat pipe, in which the number of the heat radiation fins 1750 to be joined is less than the U-shaped heat pipe 1720 with the long heat radiation part, has a great heat resistance to the cooling wind 1210 and a great temperature difference from the cooling wind 1210. Therefore, by such a configuration, even if the temperature of the cooling wind 1210 is equal to or less than the solidifying point of the coolant within the heat pipe, the coolant does not freeze, and the semiconductor element group 1500 can be efficiently cooled.

In the case where the cooler is configured by only the short-length heat pipe 1780, the number of the heat radiation fins 1750 to be joined is less than the U-shaped heat pipe, and therefore, there is a fear that the cooling performance decreases when the temperature of the cooling wind 1210 is equal to or greater than the solidifying point of the coolant. However, by mixing the short-length heat pipe 1780, the U-shaped heat pipe 1720 and the L-shaped heat pipe 1730, it is possible to have both the cooling performance when the temperature of the cooling wind 1210 is equal to or less than the solidifying point and the cooling performance when it is equal to or greater than the solidifying point.

Further, in occurrence of a dryout in which the liquid or gas coolant in the heat pipe decreases by coolant freezing, the temperature of the base of the heat radiation part of the heat pipe rises with the temperature rise of the semiconductor element group 1500. The short-length heat pipe 1780, which has a shorter heat radiation part than the U-shaped heat pipe 1720 and the L-shaped heat pipe 1730, makes it possible to reduce the temperature difference between the base and pointed-end of the heat radiation part 1782, that is, to increase the temperature of the pointed-end. Therefore, even if a dryout occurs, the frozen coolant melts and thereby starts to move, allowing for an efficient cooling of the semiconductor element group 1500.

### [Embodiment 8]

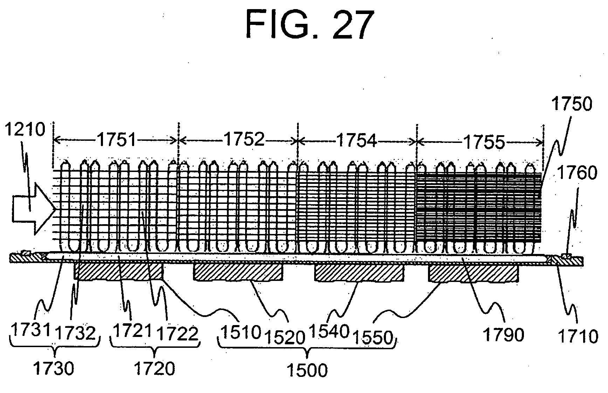

FIG. 27 illustrates a side cross-sectional view of a cooler to be mounted in a traction converter according to an eighth embodiment of the present invention. When a semiconductor element for an inverter circuit and a semiconductor element for a converter circuit are provided in an identical cooler and are cooled, or when a three-level circuit is cooled, there is sometimes a bias of the heat loss amount among the respective semiconductor elements 1510, 1520, 1540, 1550. As the eighth embodiment of the present invention, by burying a straight heat pipe 1790 in the heat receiving block 1710 such that it is overlapped with the projection planes of the respective semiconductor elements 1510, 1520, 1540, 1550, it is possible to perform the leveling of the bias of the temperature rise caused by the bias of the heat loss amount, and to efficiently cool the semiconductor element group 1500.

Here, in the first to eighth embodiments of the present invention, it has been described that the number of the heat radiation fins at the most down-wind region is 48, but the present invention is not limited to this, and an alteration may be appropriately performed. Further, the configuration in which the four semiconductor element groups 1500 are provided in the direction orthogonal to the cooling wind has been described, but the present invention is not limited to this, and an alteration can be appropriately performed depending on the circuit configuration.

## Claims

1. A traction converter comprising: plural semiconductor elements (1500) included in a traction converting circuit; and a coolers (1700) to radiate heat from the plural semiconductor elements to outside air,
the cooler (1700) including a heat receiving block (1710), plural heat pipes (1720, 1730) and plural heat radiation fins (1750), the plural semiconductor elements being arrayed on one surface of the heat receiving block, heat receiving parts of the plural heat pipes being buried in the other surface of the heat receiving block, heat radiation parts of the plural heat pipes being erectly provided so as to protrude from the heat receiving block, the plural heat radiation fins being joined to the heat radiation parts, and
the semiconductor elements being provided at three places in a cooling wind flow direction.
wherein, when regions at which the plural heat radiation fins are provided are defined at even intervals in the cooling wind flow direction as an up-wind region, a mid-wind region and a down-wind region, a heat radiation fin surface area at the up-wind region is in a range of 0.33 to 0.42 times of a heat radiation fin surface area at the down-wind region, **characterised in that**: a heat radiation fin surface area at the mid-wind region is in a range of 0.42 to 0.63 times of the heat radiation fin surface area at the down-wind region.

2. A traction converter comprising: plural semiconductor elements (1500) included in a traction converting circuit; and a cooler (1700) to radiate heat from the plural semiconductor elements to outside air,
the cooler (1700) including a heat receiving block (1710), plural heat pipes (1720, 1730) and plural heat radiation fins (1750), the plural semiconductor elements being arrayed on one surface of the heat receiving block, heat receiving parts of the plural heat pipes being buried in the other surface of the heat receiving block, heat radiation parts of the plural heat pipes being erectly provided so as to protrude from the heat receiving block, the plural heat radiation fins being joined to the heat radiation parts, and
the semiconductor elements being provided at two places in a cooling wind flow direction,
**characterised in that**, when regions at which the plural heat radiation fins are provided are defined at even intervals in the cooling wind flow direction as an up-wind region and a down-wind region, a heat radiation fin surface area at the up-wind region is in a range of 0.54 to 0.73 times of a heat radiation fin surface area at the down-wind region.

3. A traction converter comprising: plural semiconductor elements (1500) included in a traction converting circuit; and a cooler (1700) to radiate heat from the plural semiconductor elements to outside air,
the cooler including a heat receiving block (1710), plural heat pipes (1720, 1730) and plural heat radiation fins (1750), the plural semiconductor elements being arrayed on one surface of the heat receiving block, heat receiving parts of the plural heat pipes being buried in the other surface of the heat receiving block, heat radiation parts of the plural heat pipes being erectly provided so as to protrude from the heat receiving block, the plural heat radiation fins being joined to the heat radiation parts, and
the semiconductor elements being provided at four places in a cooling wind flow direction,
**characterised in that**, when regions at which the plural heat radiation fins are provided are defined at even intervals in the cooling wind flow direction as a most up-wind region, an up-wind region, a down-wind region and a most down-wind region, a heat radiation fin surface area at the most up-wind region is in a range of 0.21 to 0.42 times of a heat radiation fin surface area at the most down-wind region, a heat radiation fin surface area at the up-wind region is in a range of 0.25 to 0.63 times of the heat radiation fin surface area at the most down-wind region, and a heat radiation fin surface area at the down-wind region is in a range of 0.42 to 0.73 times of the heat radiation fin surface area at the most down-wind region.

4. A railway vehicle having the traction converter according to any one of claims 1 to 3 mounted under a floor of a passenger compartment.

## Patentansprüche

1. Traktionsumrichter mit mehreren in einer Traktionsumrichtschaltung enthaltenen Halbleiterelementen (1500) und einem Kühler (1700) zum Abstrahlen von Wärme von den mehreren Halbleiterelementen an Umgebungsluft,
wobei der Kühler (1700) einen Wärmeaufnahmeblock (1710), mehrere Wärmeleitungen (1720, 1730) und mehrere Wärmeabstrahlungsrippen (1750) aufweist, wobei die mehreren Halbleiterelemente auf einer Fläche des Wärmeaufnahmeblocks angeordnet sind, Wärmeaufnahmeteile der mehreren Wärmeleitungen in der anderen Fläche des Wärmeaufnahmeblocks eingebettet sind, Wärmeabstrahlungsteile der mehreren Wärmeleitungen aufrecht vorgesehen sind, so dass sie aus dem Wärmeaufnahmeblock hervorragen, die mehreren Wärmeabstrahlungsrippen mit den Wärmeabstrahlungsteilen verbunden sind, und
die Halbleiterelemente an drei Stellen in einer Kühlwindströmungsrichtung vorgesehen sind,
wobei, wenn Bereiche, an denen die mehreren Wärmeabstrahlungsrippen vorgesehen sind, in gleichen Abständen in der Kühlwind-Strömungsrichtung als ein oberer Windbereich, ein mittlerer Windbereich und ein unterer Windbereich definiert sind, eine Wärmeabstrahlungsrippen-Oberfläche in dem oberen Windbereich zwischen dem 0,33- und dem 0,42-fachen einer Wärmeabstrahlungsrippen-Oberfläche in dem unteren Windbereich beträgt,
**dadurch gekennzeichnet, dass** eine Wärmeabstrahlungsrippen-Oberfläche in dem mittleren Windbereich zwischen dem 0,42- und dem 0,63-fachen der Wärmeabstrahlungsrippen-Oberfläche in dem unteren Windbereich beträgt.

2. Traktionsumrichter mit mehreren in einer Traktionsumrichtschaltung enthaltenen Halbleiterelementen (1500) und einem Kühler (1700) zum Abstrahlen von Wärme von den mehreren Halbleiterelementen an Umgebungsluft,
wobei der Kühler (1700) einen Wärmeaufnahmeblock (1710), mehrere Wärmeleitungen (1720, 1730) und mehrere Wärmeabstrahlungsrippen (1750) aufweist, wobei die mehreren Halbleiterelemente auf einer Fläche des Wärmeaufnahmeblocks angeordnet sind, Wärmeaufnahmeteile der mehreren Wärmeleitungen in der anderen Fläche des Wärmeaufnahmeblocks eingebettet sind, Wärmeabstrahlungsteile der mehreren Wärmeleitungen aufrecht vorgesehen sind, so dass sie aus dem Wärmeaufnahmeblock hervorragen, die mehreren Wärmeabstrahlungsrippen mit den Wärmeabstrahlungsteilen verbunden sind, und
die Halbleiterelemente an zwei Stellen in einer Kühlwindströmungsrichtung vorgesehen sind,
**dadurch gekennzeichnet, dass**, wenn Bereiche, an denen die mehreren Wärmeabstrahlungsrippen vorgesehen sind, in gleichen Abständen in der Kühlwind-Strömungsrichtung als ein oberer Windbereich und ein unterer Windbereich definiert sind, eine Wärmeabstrahlungsrippen-Oberfläche in dem oberen Windbereich zwischen dem 0,54- und dem 0,73-fachen einer Wärmeabstrahlungsrippen-Oberfläche in dem unteren Windbereich beträgt.

3. Traktionsumrichter mit mehreren in einer Traktionsumrichtschaltung enthaltenen Halbleiterelementen (1500) und einem Kühler (1700) zum Abstrahlen von Wärme von den mehreren Halbleiterelementen an Umgebungsluft,
wobei der Kühler (1700) einen Wärmeaufnahmeblock (1710), mehrere Wärmeleitungen (1720, 1730) und mehrere Wärmeabstrahlungsrippen (1750) aufweist, wobei die mehreren Halbleiterelemente auf einer Fläche des Wärmeaufnahmeblocks angeordnet sind, Wärmeaufnahmeteile der mehreren Wärmeleitungen in der anderen Fläche des Wärmeaufnahmeblocks eingebettet sind, Wärmeabstrahlungsteile der mehreren Wärmeleitungen aufrecht vorgesehen sind, so dass sie aus dem Wärmeaufnahmeblock hervorragen, die mehreren Wärmeabstrahlungsrippen mit den Wärmeabstrahlungsteilen verbunden sind, und
die Halbleiterelemente an vier Stellen in einer Kühlwindströmungsrichtung vorgesehen sind,
**dadurch gekennzeichnet, dass**, wenn Bereiche, an denen die mehreren Wärmeabstrahlungsrippen vorgesehen sind, in gleichen Abständen in der Kühlwind-Strömungsrichtung als ein oberster Windbereich, ein oberer Windbereich, ein unterer Windbereich und ein unterster Windbereich definiert sind, eine Wärmeabstrahlungsrippen-Oberfläche in dem obersten Windbereich zwischen dem 0,21- und dem 0,42-fachen einer Wärmeabstrahlungsrippen-Oberfläche in dem untersten Windbereich beträgt, eine Wärmeabstrahlungsrippen-Oberfläche in dem oberen Windbereich zwischen dem 0,25- und dem 0,63-fachen der Wärmeabstrahlungsrippen-Oberfläche in dem untersten Windbereich beträgt, und eine Wärmeabstrahlungsrippen-Oberfläche in dem unteren Windbereich zwischen dem 0,42- und dem 0,73-fachen der Wärmeabstrahlungsrippen-Oberfläche in dem untersten Windbereich beträgt.

4. Schienenfahrzeug mit dem Traktionsumrichter gemäß einem der Ansprüche 1 bis 3, der unter einem Boden eines Passagierabteils befestigt ist.

## Revendications

1. Convertisseur de traction comportant : une pluralité d'éléments à semi-conducteurs (1500) inclus dans un circuit de conversion de traction, et un refroidisseur (1700) pour transmettre de la chaleur par rayonnement à partir de la pluralité d'éléments à semi-conducteurs vers l'air extérieur,
le refroidisseur (1700) incluant un bloc de réception thermique (1710), une pluralité de caloducs (1720, 1730) et une pluralité d'ailettes de rayonnement thermique (1750), la pluralité d'éléments à semi-conducteurs étant disposée en mosaïque sur une surface du bloc de réception thermique, des pièces de réception thermique de la pluralité de caloducs étant enterrées dans l'autre surface du bloc de réception thermique, des pièces de rayonnement thermique de la pluralité de caloducs étant agencées de manière dressée de manière à faire saillie à partir du bloc de réception thermique, la pluralité d'ailettes de rayonnement thermique étant reliée aux pièces de rayonnement thermique, et
les éléments à semi-conducteurs étant agencés à trois emplacements dans une direction d'écoulement de vent de refroidissement,
dans lequel, lorsque des régions sur lesquelles la pluralité d'ailettes de rayonnement thermique est agencée sont définies à intervalles réguliers dans la direction d'écoulement de vent de refroidissement comme une région de vent en amont, une région de vent intermédiaire et une région de vent en aval, l'aire de surface d'ailette de rayonnement thermique sur la région de vent en amont est dans une plage de 0,33 à 0,42 fois une aire de surface d'ailette de rayonnement thermique sur la région de vent en aval,
caractérisé ce que : une aire de surface d'ailette de rayonnement thermique sur la région de vent intermédiaire est dans une plage de 0,42 à 0,63 fois l'aire de surface d'ailette de rayonnement thermique sur la région de vent en aval.

2. Convertisseur de traction comportant : une pluralité d'éléments à semi-conducteurs (1500) inclus dans un circuit de conversion de traction, et un refroidisseur (1700) pour transmettre de la chaleur par rayonnement à partir de la pluralité d'éléments à semi-conducteurs vers l'air extérieur,
le refroidisseur (1700) incluant un bloc de réception thermique (1710), une pluralité de caloducs (1720, 1730) et une pluralité d'ailettes de rayonnement thermique (1750), la pluralité d'éléments à semi-conducteurs étant disposée en mosaïque sur une surface du bloc de réception thermique, des pièces de réception thermique de la pluralité de caloducs étant enterrées dans l'autre surface du bloc de réception thermique, des pièces de rayonnement thermique de la pluralité de caloducs étant agencées de manière dressée de manière à faire saillie à partir du bloc de réception thermique, la pluralité d'ailettes de rayonnement thermique étant reliée aux pièces de rayonnement thermique, et
les éléments à semi-conducteurs étant agencés à deux emplacements dans une direction d'écoulement de vent de refroidissement,
**caractérisé en ce que**, lorsque des régions sur lesquelles la pluralité d'ailettes de rayonnement thermique est agencée sont définies à intervalles réguliers dans la direction d'écoulement de vent de refroidissement comme une région de vent en amont et une région de vent en aval, une aire de surface d'ailettes de rayonnement thermique sur la région de vent en amont est dans une plage de 0,54 à 0,73 fois une aire de surface d'ailette de rayonnement thermique sur la région de vent en aval.

3. Convertisseur de traction comportant : une pluralité d'éléments à semi-conducteurs (1500) inclus dans un circuit de conversion de traction, et un refroidisseur (1700) pour transmettre de la chaleur par rayonnement à partir de la pluralité d'éléments à semi-conducteurs vers l'air extérieur,
le refroidisseur incluant un bloc de réception thermique (1710), une pluralité de caloducs (1720, 1730) et une pluralité d'ailettes de rayonnement thermique (1750), la pluralité d'éléments à semi-conducteurs étant disposée en mosaïque sur une surface du bloc de réception thermique, des pièces de réception thermique de la pluralité de caloducs étant enterrées dans l'autre surface du bloc de réception thermique, des pièces de rayonnement thermique de la pluralité de caloducs étant agencées de manière dressée de manière à faire saillie à partir du bloc de réception thermique, la pluralité d'ailettes de rayonnement thermique étant reliée aux pièces de rayonnement thermique, et
les éléments à semi-conducteurs étant agencés à quatre emplacements dans une direction d'écoulement de vent de refroidissement,
**caractérisé en ce que**, lorsque des régions sur lesquelles la pluralité d'ailettes de rayonnement thermique est agencée sont définies à intervalles réguliers dans la direction d'écoulement de vent de refroidissement comme une région de vent la plus en amont, une région de vent en amont, une région de vent en aval et une région de vent la plus en aval, une aire de surface d'ailette de rayonnement thermique sur la région de vent la plus en amont est dans une plage de 0,21 à 0,42 fois une aire de surface d'ailette de rayonnement thermique sur la région de vent la plus en aval, une aire de surface d'ailette de rayonnement thermique sur la région de vent en amont est dans une plage de 0,25 à 0,63 fois l'aire de surface d'ailette de rayonnement thermique sur la région de vent la plus en aval, et une aire de surface d'ailette de rayonnement thermique sur la région de vent en aval est dans une plage de 0,42 à 0,73 fois l'aire de surface d'ailette de rayonnement thermique sur la région de vent la plus en aval.

4. Véhicule ferroviaire ayant le convertisseur de traction selon l'une quelconque des revendications 1 à 3 monté sous un plancher d'un compartiment de passagers.
